# EUROPEAN PATENT APPLICATION

(11) **EP 2 019 155 A2**
(43) Date of publication of application: **28.01.2009**
(21) Application number: 08008309.0
(22) Date of filing: 30.04.2008
(51) Int. Cl.: C30B 25/02, C30B 29/40

(54) **Gallium nitride substrate and gallium nitride film deposition method**

(30) Priority: 02.05.2007 JP 2007121770; 15.01.2008 JP 2008006046
(71) Applicant: Sumitomo Electric Industries, Ltd., Osaka-shi, Osaka 541-0041 (JP)
(72) Inventor: Nakahata, Seiji, Itami-shi Hyogo (JP)
(74) Representative: Grünecker, Kinkeldey, Stockmair & Schwanhäusser Anwaltssozietät

(57) **Abstract**

Affords high-carrier-concentration, low-cracking-incidence gallium nitride substrates and methods of forming gallium nitride films. A gallium nitride film 52 in which the carrier concentration is 1 × 10¹⁷ cm⁻³ or more is created. Initially, a gallium nitride layer 51 including an *n*-type dopant is formed onto a substrate 50. Then, the gallium nitride layer 51 formed on the substrate 50 is heated to form a gallium nitride film 52.

## Description

### Technical Field

The present invention relates to gallium nitride substrates and to methods of forming gallium nitride films.

### Description of the Related Art

*N*-type gallium nitride substrates incorporating oxygen, silicon, or other *n*-type dopants are known-for example, as disclosed in Japanese Unexamined Pat. App. Pub. No. 2000-44400. The carrier concentrations in these gallium nitride substrates are 1 × 10¹⁶ cm⁻³ to 1 × 10²⁰ cm⁻³.

Jacking up the level of the *n*-dopant concentration in order to raise the carrier concentration, like in the gallium nitride substrates just noted, tends to make the gallium nitride crystal brittle, however. As a consequence, the incidence of cracking in gallium-nitride-substrate manufacturing operations, as well as in GaN-substrate-employing epitaxial growth and device-manufacturing processes, rises detrimentally. Any cracking in a gallium nitride substrate makes it defective. Thus, there is still room for improvement in gallium nitride substrates, and in yields in GaN-substrate-employing epitaxial growth and device manufacture. Brief Summary of the Invention

An object of the present invention, brought about in view of the circumstances described above, is to make available high carrier-concentration, low cracking-incidence gallium nitride substrates and gallium-nitride-film deposition methods.

To address the foregoing issues, a gallium-nitride-film deposition method in one aspect of the present invention is a method of forming a gallium nitride layer with a carrier concentration of 1 x 10¹⁷ cm⁻³ or more, the method including a step of forming on a substrate a gallium nitride layer containing an *n*-type dopant, and a step of heating the gallium nitride layer formed on the substrate.

In the gallium-nitride-film deposition method of the present invention, heating the *n*-type dopant-containing gallium nitride layer enables forming a gallium nitride film having a low incidence of cracking. The reason for this is not exactly clear, but is thought to be as follows. *N*-type dopants settle interstitially, with a high degree of probability, into the gallium (Ga)- and nitrogen (N)- constituted crystalline lattice, where they impart strain in the crystal. When the gallium nitride film is heated, the interstitially present *n*-type dopants migrate into Ga or N sites. As a result, the incidence of cracking in the gallium nitride film falls. Meanwhile, the carrier concentration in the gallium nitride film rises to a high 1 x 10¹⁷ cm⁻³ or more.

Moreover, the gallium nitride layer is preferably heated at a temperature of 800°C or more for 5 minutes or more. Doing so makes it possible to further lower the incidence of cracking.

Also, the gallium nitride layer is preferably heated at a ramp-down rate of 50°C/min or less. Doing so makes it possible to lower the incidence of cracking still further.

Additionally, the surface of the gallium nitride film is preferably inclined from the film's (0001) plane at an angle of 0.03° or more. Inclining the film surface from its (0001) plane at an angle of 0.03° or more further reduces the incidence of cracking. The reason for this is not exactly clear, but is thought to be as follows. Microscopic steps form on the surface of the gallium nitride film, wherein the *n*-type dopant, filling the steps in from their corners, is thus more likely to enter a Ga or N site. As a result, the incidence of cracking in the gallium nitride film is reduced.

Furthermore, the gallium nitride layer preferably has a dislocation density of 1 x 10⁷ cm⁻² or less. With the layer dislocation density being 1 x 10⁷ cm⁻² or less, the incidence of cracking can be reduced still further. The reason for this is not exactly clear, but is thought to be as follows. Generally, *n*-type dopants tend to concentrate into the interspace proximate the dislocations, and if an *n*-type dopant concentrates into specific locations, the incidence of cracking rises. Herein, with the dislocation density of the gallium nitride layer being 1 x 10⁷ cm⁻² or less, in the gallium nitride lyer the *n*-type dopant disperses throughout the entire layer, and therefore the incidence of cracking decreases.

A gallium-nitride-film deposition method of the present invention in another aspect includes a step of forming on a substrate a gallium nitride layer having a carrier concentration of 1 x 10¹⁷ cm⁻³ or more, and containing an *n*-type dopant, with the surface of the gallium nitride layer being inclined from the layer's (0001) plane at an angle of 0.03° or more.

A gallium-nitride-film deposition method of the present invention makes it possible to form a gallium nitride film having a low incidence of cracking. The reasons behind this advantage have not been precisely elucidated, but are thought to be as follows. Microscopic steps form on the surface of the gallium nitride film, and the *n*-type dopant fills the steps in from their corners, which makes the dopant more likely to enter a Ga or N site. As a result, the incidence of cracking in the gallium nitride film decreases. Furthermore, the carrier concentration in the gallium nitride layer proves to be a high 1 x 10¹⁷ cm⁻³ or more.

Moreover, the gallium nitride layer in this aspect of the invention as well preferably has a dislocation density of 1 x 10⁷ cm⁻² or less. With the layer dislocation density being 1 x 10⁷ cm⁻² or less, the incidence of cracking can be reduced still further. The reasons behind this advantage have not been precisely elucidated, but are thought to be as follows. *N*-type dopants generally tend to concentrate into the interspace proximate the dislocations, and if an *n*-type dopant concentrates into specific locations, the incidence of cracking rises. Herein, with the gallium nitride layer dislocation density being 1 x 10⁷ cm⁻² or less, in the gallium nitride layer the *n*-type dopant disperses throughout the entire layer, and therefore the incidence of cracking decreases.

A gallium nitride substrate in another aspect of the present invention contains an *n*-type dopant, and its surface is inclined from the substrate's (0001) plane at an angle of 0.03° or more, with the carrier concentration in the substrate being 1 x 10¹⁷ cm⁻³ or more.

The carrier concentration in a gallium nitride substrate of the present invention is a high 1 x 10¹⁷ cm⁻³ or more. Furthermore, the incidence of cracking in the gallium nitride substrate of the present invention is low. Although the reasons behind this advantage have not been precisely elucidated, it is believed that because inclining the substrate surface at an angle of at least 0.03° causes the GaN to grow stepwise, making Si (for example) more likely to enter Ga sites, and O (for example) more likely to enter N sites, strain in the crystal is lessened.

Additionally, the gallium nitride substrate preferably has a dislocation density of 1 × 10⁷ cm⁻² or less. With the substrate dislocation density being 1 x 10⁷ cm⁻² or less, the incidence of cracking can be reduced still further. The reasons behind this advantage have not been precisely elucidated, but are thought to be as follows. *N*-type dopants generally tend to concentrate into the interspace proximate the dislocations, and if an *n*-type dopant concentrates into specific locations, the incidence of cracking rises. Herein, with the gallium nitride layer dislocation density being 1 x 10⁷ cm⁻² or less, in the gallium nitride layer the *n*-type dopant disperses throughout the entire layer, and therefore the incidence of cracking decreases.

The present invention affords gallium nitride substrates and methods of forming gallium nitride films, wherein the carrier concentration is high, while the incidence of cracking is low.

From the following detailed description in conjunction with the accompanying drawings, the foregoing and other objects, features, aspects and advantages of the present invention will become readily apparent to those skilled in the art.

### Brief Description of the Several Views of the Drawings

Fig. 1 is a diagram schematically illustrating a hydride-VPE reactor for forming an *n*-type dopant-containing gallium nitride layer onto a substrate.

Fig. 2 is process diagrams schematically representing a gallium-nitride-film deposition method involving embodiment modes of the present invention, a gallium-nitride-substrates manufacturing method employing the gallium nitride film, and an epitaxial-substrate manufacturing method employing the gallium nitride substrate.

Fig. 3 is graphs plotting specific examples of substrate temperature variation with time.

Fig. 4 is a diagram representing a gallium nitride layer formation stage.

Fig. 5 is a diagram representing a gallium nitride substrate manufacturing stage.

Fig. 6 is a table showing the results of tests when GaN layers were formed in Reference Examples 1-1 and 1-2, and Embodiments 1-1 to 2-4.

Fig. 7 is a table showing the results of tests when GaN layers were formed in Embodiments 3-1 and 3-2.

Fig. 8 is a table showing the results of tests when GaN layers were formed in Embodiments 4-1 to 4-54.

Fig. 9 is a table showing the results of tests when GaN layers were formed in Embodiments 5-1 to 5-8.

Fig. 10 is a table showing the results of tests when GaN layers were formed in Embodiments 6-1 to 6-10.

Fig. 11 is a table showing the results of tests when GaN layers were formed in Embodiments 7-1 to 10-2.

Fig. 12 is a table showing the results of tests when GaN layers were formed in Reference Examples 2-1 and 2-2, and Embodiments 11-1 to 12-4.

Fig. 13 is a table showing the results of tests when GaN layers were formed in Embodiments 13-1 and 13-2.

Fig. 14 is a table showing the results of tests when GaN layers were formed in Embodiments 14-1 to 14-54.

Fig. 15 is a table showing the results of tests when GaN layers were formed in Embodiment 15-1 to 15-8.

Fig. 16 is a table showing the results of tests when GaN layers were formed in Embodiments 16-1 to 16-10.

Fig. 17 is a table showing the results of tests when GaN layers were formed in Embodiments 17-1 to 20-2.

Fig. 18 is a cross-sectional diagram of an LED.

Fig. 19 is cross-sectional diagrams of an LD.

Fig. 20 is a cross-sectional diagram of an HEMT.

Fig. 21 is a cross-sectional diagram of a Schottky diode.

Fig. 22 is a cross-sectional diagram of a vertical MIS transistor.

Fig. 23 is a table showing yields when semiconductor devices were fabricated in Reference Examples 3-1 to 4-2, and Embodiments 21-1 to 22-3.

Fig. 24 is a table showing yields when semiconductor devices were fabricated in Reference Examples 5-1 to 6-2, and Embodiments 23-1 to 24-3.

Fig. 25 is a table showing yields when semiconductor devices were fabricated in Reference Examples 7 to 9, and Embodiments 25 to 27.

### Detailed Description of the Invention

Hereinafter, referring to the accompanying drawings, an explanation of embodiment modes of the present invention will be made in detail. It should be understood that in describing the drawings, with the same reference marks being used for identical or equivalent features, reduplicating description will be omitted.

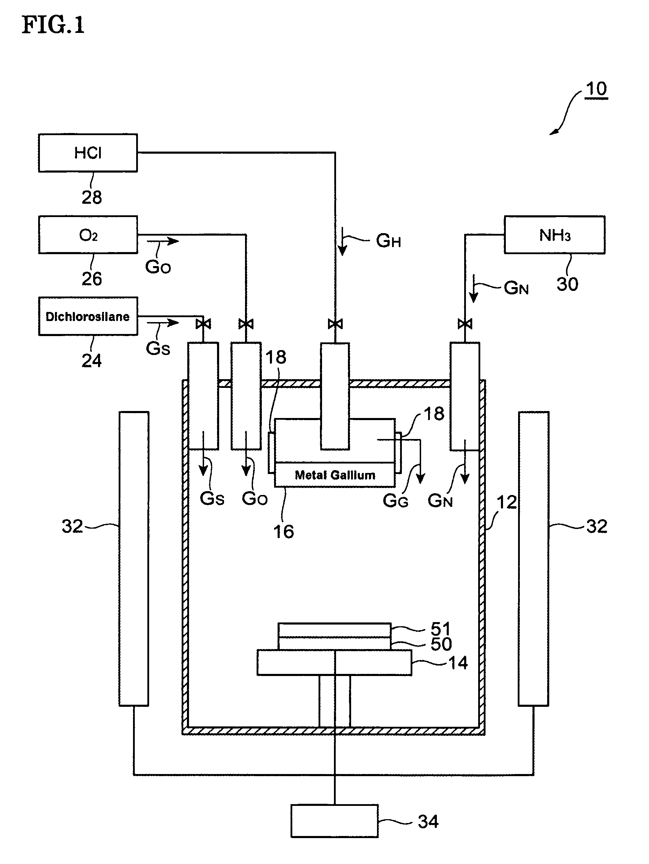

Fig. 1 is a diagram schematically illustrating a hydride-VPE reactor for forming onto a substrate a gallium nitride layer containing an *n*-type dopant. The hydride-VPE reactor 10 illustrated in Fig. 1 is provided with a growth furnace 12 that houses a substrate 50, for growing a gallium nitride layer 51, and with a susceptor 14 for supporting the substrate 50.

A nitrogen supply source 30 for supplying NH₃ gas *G_{N}* to the inside of the growth furnace 12 is connected to the growth furnace 12. In the growth furnace 12, a gallium supply source 16 for supplying a gallium-containing gas *G_{G}* to the inside of the growth furnace 12 is disposed. The gallium supply source 16 is a source boat in which, for example, metal gallium is contained. An HCl supply source 28 for supplying HCl gas *G_{H}* with which the metal gallium is reacted is connected to the gallium supply source 16. A heater 18 for heating the metal gallium and HCl gas *G_{H}* is mounted on the gallium supply source 16. The heater 18 keeps the gallium supply source 16 at a temperature of, for example, 800°C or more. Reacting the metal gallium with the HCl gas *G_{H}* at a high temperature produces a gallium-containing gas *G_{G},* such as GaCl. An example of the chemical reaction formula is presented below.

2Ga (1) + 2HCl (g) → 2GaCl (g) + H₂ (g)

A silicon supply source 24 for supplying a silicon-containing gas *G_{S}* composed of a silane compound such as dichlorosilane is connected to the growth furnace 12. Examples of the silicon-containing gas *G_{S}* include: gases such as SiH₄, SiH₃Cl, SiH₂Cl₂, SiHCl₃, SiCl₄; gases produced from a reaction of granular Si with HCl; and gases produced from the reaction of SiO₂ with HCl or NH₃.

Also, an oxygen supply source 26 for supplying an oxygen-containing gas *Gₒ* such as O₂ may be connected to the growth furnace 12. At least one of either the silicon-containing gas *Gₛ* or oxygen-containing gas *Gₒ* is supplied to the growth furnace 12.

Surrounding the growth furnace 12, a heater 32 for heating the NH₃ gas G_{N}, gallium-containing gas *G_{G}*, silicon-containing gas *G_{S},* and oxygen-containing gas *Gₒ* is installed. A controller 34 for monitoring the temperature of the substrate 50 is connected to the heater 32. The controller 34 controls the heater 32 so as to keep the substrate 50 at the predetermined temperature. By reacting at a high temperature the NH₃ gas *G_{N},* gallium-containing gas *G_{G},* silicon-containing gas *G_{S},* and oxygen-containing gas *Gₒ* with each other, a gallium nitride layer 51 containing *n*-type dopants is formed on the substrate 50. An example of the chemical reaction formula is presented below.

GaCl (g) + NH₃ (g) → GaN (s) + HCl (g) + H₂ (g)

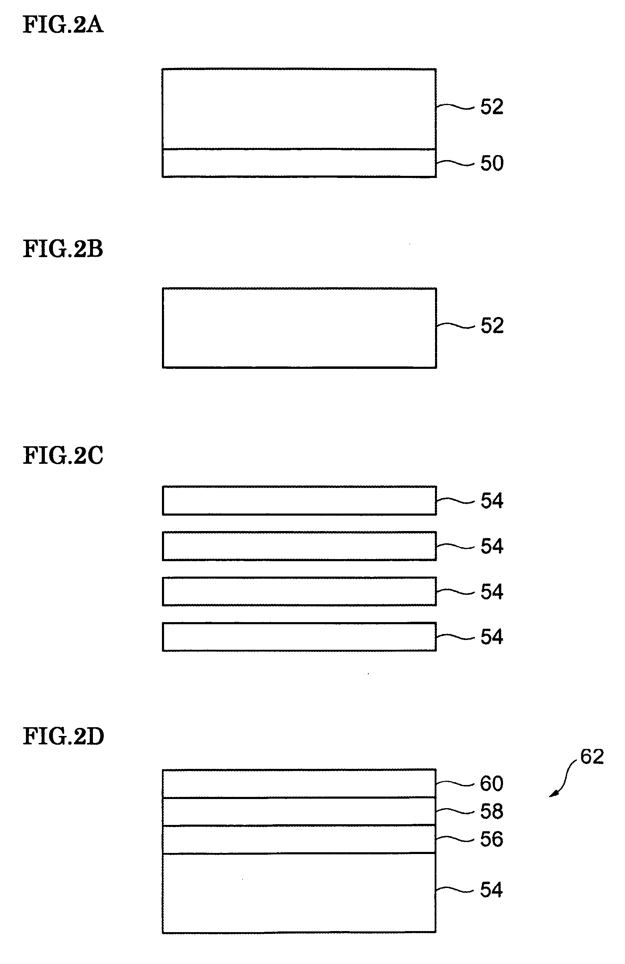

Figs. 2A through 2D are process diagrams schematically representing a gallium-nitride-film deposition method involving the present invention, a method of producing a gallium nitride substrate employing the gallium nitride layer, and a method of manufacturing an epitaxial substrate employing the gallium nitride substrate.

First, the substrate 50 is placed on the susceptor 14 in the hydride-VPE reactor 10 illustrated in Fig. 1. Next, the hydride-VPE reactor 10 is employed to form onto the substrate 50 an *n*-type gallium nitride film 52 as illustrated in Fig. 2A, containing an *n*-type dopant. Subsequently, as illustrated in Fig. 2B, the substrate 50 is removed to yield a freestanding gallium nitride film 52. And then, as illustrated in Fig. 2C, the gallium nitride film 52 is sliced with, for example, an internal-diameter saw into a plurality of freestanding gallium nitride substrates 54. The gallium nitride substrates 54 are preferably ground and polished after the gallium nitride film 52 is sliced. The thickness of the gallium nitride substrates 54 is preferably 100 *µ*m or more.

Next, as illustrated in Fig. 2D, nitride semiconductor layers 56, 58 and 60 are formed successively on the gallium nitride substrates 54 to produce epitaxial substrates 62. The nitride semiconductor layers 56, 58 and 60 are Al*ₓ*In*_{y}*Ga_{1*-x-y*}N layers (0 ≤ *x* ≤ 1, 0 ≤ *y* ≤ 1), for example. The epitaxial substrates 62 are exploited principally in electronic and optical devices. Examples of such electronic devices include field-effect transistors. Examples of such optical devices include semiconductor lasers, and LEDs.

### Embodiment Mode 1

A gallium-nitride-film deposition method involving Embodiment Mode 1 is carried out as follows.

First, the hydride-VPE reactor 10 illustrated in Fig. 1 is employed to form onto the substrate 50 a gallium nitride layer 51 containing a silicon, oxygen, or other *n*-type dopant. In order to discontinue growth of the gallium nitride layer 51, the HCl gas supply is stopped, for example. The temperature (growth temperature) of the substrate 50 during the formation of the gallium nitride layer 51 is preferably from 920 to 1250°C. With the growth temperature being from 920 to 1250°C, a high-quality gallium nitride layer 51 having fewer crystal defects can be obtained. The time required for the growth is exemplarily 1 hour, and exemplary partial pressures of the NH₃ gas *G_{N}* and HCl gas *G_{H}* are respectively 15200 Pa and 304 Pa.

Examples of the substrate 50 include sapphire, gallium nitride, GaAs, SiC, GaP, and InP substrates. With sapphire and SiC substrates, the surface on which the gallium nitride layer is grown is preferably the substrate's (0001) plane. With the GaAs, GaP, InP substrates, the surface on which a gallium nitride layer is grown is preferably the substrate's (111)A plane (Group III plane). If a substrate other than a gallium nitride substrate is utilized as the substrate 50, a mask layer having a perforated pattern is preferably formed on the substrate 50. The mask layer may be composed an insulator such as silicon oxide. The thickness of the mask layer is for example 100 nm.

Next, the gallium nitride layer 51 formed on the substrate 50 is heated (annealed). This enables a gallium nitride film 52, as illustrated in Fig. 2A, to be formed on the substrate 50. Subsequently, as illustrated in Fig. 2B, the substrate 50 is removed to obtain a freestanding gallium nitride film 52. The gallium nitride film 52 is composed of hexagonal GaN single crystal. The gallium nitride film 52 is for example 7 mm in thickness, and 50 mm in diameter. The temperature (heating temperature) of the substrate 50 during the heating of the gallium nitride layer 51 is preferably from 800 to 1200°C. The heating time is preferably from 5 to 300 minutes. During the heating period, the heating temperature may be maintained at the same level, or may be gradually ramped down.

The carrier concentration in the gallium nitride film 52 is preferably 1 × 10¹⁷ cm⁻³ or more, with up to 5 × 10¹⁹ cm⁻³ being more preferable. The carrier concentration in the gallium nitride film 52 is raised by, for example, increasing the concentration of *n*-type dopant in the gallium nitride film 52. The carrier concentration in the gallium nitride film 52 is characterized by Hall measurement. Thickness of the gallium nitride film 52 is preferably 100 *µ*m or more, with 400 *µ*m or more being more preferable.

The concentration of *n*-type dopant in the gallium nitride film 52 is preferably from 3 x 10¹⁷ cm⁻³ or more to as much as 5 x 10¹⁹ cm⁻³. With the *n*-type dopant concentration being in this range, crystallinity degradation caused by the addition of a large amount of *n*-type dopants can be prevented. The concentration of *n*-type dopant in the gallium nitride film 52 is measured by secondary ion mass spectrometry (SIMS).

Herein, a buffer layer composed of gallium nitride may be formed on the substrate 50 before the gallium nitride layer 51 is formed. The buffer layer is 60 nm in thickness, for example. The temperature of the substrate 50 during the buffer layer formation is 500°C, for example. Forming the buffer layer heightens the crystallinity of the gallium nitride layer 51.

In the gallium-nitride-film deposition method of Embodiment Mode 1, heating the gallium nitride layer 51 makes it possible to form a gallium nitride film 52 in which the incidence of cracking is low. The reason why, although not precisely elucidated, is thought to be as follows. *N*-type dopants settle interstitially, with a high degree of probability, into the gallium (Ga)- and nitrogen (N)- constituted crystalline lattice, on account of which the crystal deforms. When the gallium nitride layer 51 is heated, the interstitially present *n*-type dopants migrate into Ga or N sites. As a result, the incidence of cracking in the gallium nitride film 52 falls. Therefore, yields in manufacturing the gallium nitride film 52 can be heightened. The surface of the gallium nitride film 52 is checked for occurrences of cracking by observing the gallium-nitride-layer 52 surface under a microscope. Furthermore, the carrier concentration in the gallium nitride film 52 proves to be a high 1 × 10¹⁷ cm⁻³ or more.

Herein, specifically, the presence of cracking in the surface of the gallium nitride film 52 can be checked by observation under a differential interference microscope. The characterization for cracks is performed right before the front side, back side, and outer periphery of the gallium nitride film 52 are processed, and epitaxial growth is carried out. The observation zone on the surface of the gallium nitride film 52 is the entire surface of the substrates except for a 5 mm outer margin, and the magnification through the field lens is set to be 20 x. In discovering cracks, 10 or more cracks 100 *µ*m or more in length were deemed "cracking present," disqualifying the film, which was not permitted to proceed to the final processing.

Furthermore, heating the gallium nitride layer 51 at a temperature of 800°C or more for 5 minuets or more enables further lowering the crack incidence. Preferable is that the gallium nitride layer 51 is heated at a temperature of 800 to 1200°C for 5 to 300 minutes. Moreover, heating the gallium nitride layer 51 at a ramp-down rate of 50°C/min or less makes it possible to further reduce the crack incidence. Preferable is that the gallium nitride layer 51 is heated at a ramp-down rate of more than 0°C/min to 50°C/min or less.

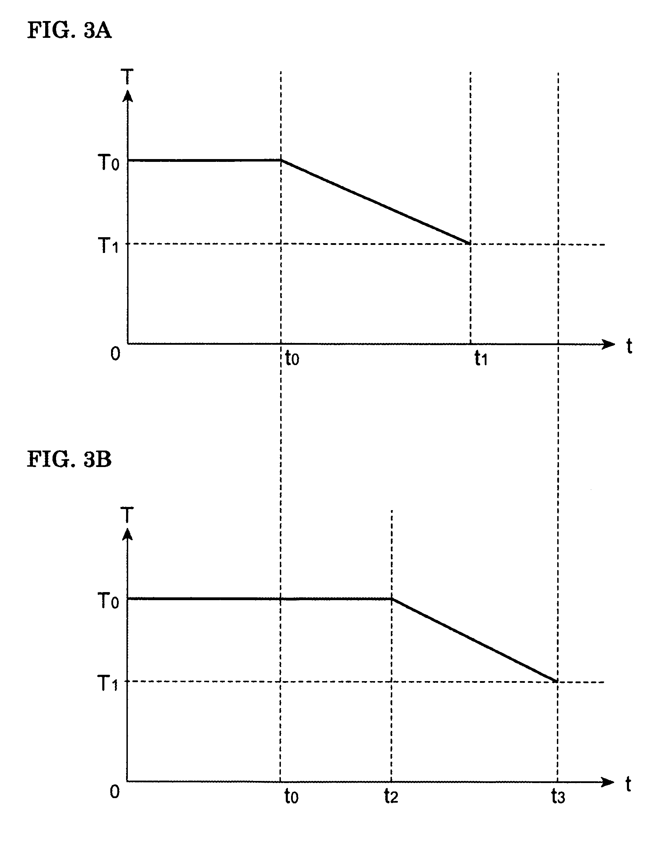

Figs. 3A and 3B are graphs showing specific examples of changes with time in temperature of the substrate 50. As shown in Figs. 3A and 3B, with the temperature of the substrate 50 being kept at growth temperature of *T₀* (for example, *T₀* = 1100°C) from time 0 to time *t₀,* the gallium nitride layer 51 forms on the substrate 50. Time 0 is the point when growth of the gallium nitride layer 51 is started, and time *t₀* is the point when the growth of the gallium nitride layer 51 is stopped. Next, as shown in Fig. 3A, the gallium nitride layer 51 is heated while the temperature is decreased at a ramp-down rate of 50°C/min or less from time *t₀* to time *t₁.* As a result, the gallium nitride film 52 is formed on the substrate 50. At the time *t₁,* the temperature of the substrate 50 has dropped to the annealing end temperature *T₁* (for example, *T₁* = 500°C). After the gallium nitride layer 51 forms on the substrate 50, the gallium nitride layer 51 may be heated from time *t₀* to time *t₂* at the growth temperature of *T₀,* as shown in Fig. 3B. Subsequently, the gallium nitride layer 51 may be heated while the growth temperature is being decreased from the time *t₂* to time *t₃* at a chosen ramp-down rate. As a result, a gallium nitride film 52 forms on the substrate 50. The temperature of the substrate 50 drops to the annealing end temperature *T₁* at time *t₃*.

After being formed on the substrate 50, the gallium nitride film 52 is subjected to the steps represented in Figs. 2B and 2C to produce gallium nitride substrates 54. In the gallium nitride substrates 54, the carrier concentration is 1 × 10¹⁷ cm⁻³ or more, and the incidence of cracking is low. The surface of the gallium nitride substrates 54 is checked for occurrences of cracking by observing the surface under a differential interference microscope. Subsequently, each gallium nitride substrate 54 goes through the process represented in Fig. 2D, whereby an epitaxial substrate 62 is produced.

### Embodiment Mode 2

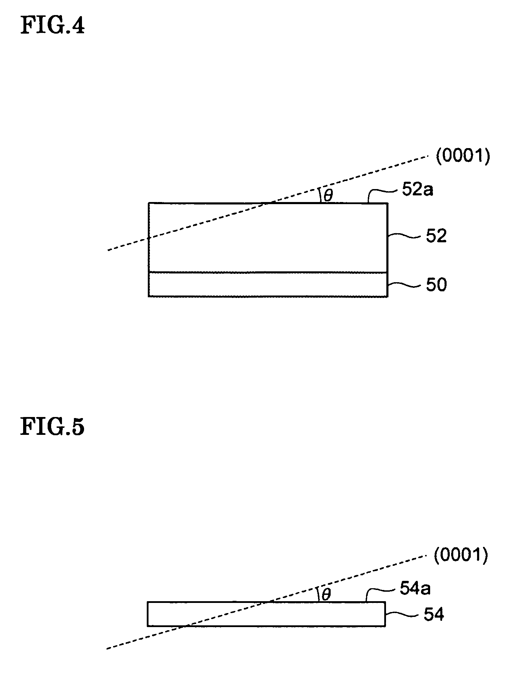

A gallium-nitride-film deposition method involving Embodiment Mode 2 is carried out as follows. The the hydride-VPE reactor 10 is employed to form on the substrate 50 a gallium nitride film 52 as illustrated in Fig. 4, having a carrier concentration of 1 x 10¹⁷ cm⁻³ or more and containing an *n*-type dopant. Fig. 4 is a diagram representing a gallium nitride layer formation stage. Herein, the surface 52*a* of the gallium nitride film 52 is inclined from the (0001) plane (also termed the *c*-plane) of the gallium nitride film 52 at an angle of 0.03° or more. That is, the angle *θ* (also termed the off-axis angle) formed by the surface 52*a* and the (0001) plane of the gallium nitride film 52 is 0.03° or more. The angle *θ* is preferably from 0.5° to 60°. The angle *θ* is measured by X-ray diffraction.

The surface 52*a* of the gallium nitride film 52 may be a plane obtained by inclining the normal to the (0001) plane in a <11-20> direction by the angle *θ*, or may be a plane obtained by inclining the normal to the (0001) plane in a <1-100> direction by the angle *θ*.

The substrate 50 may be a gallium nitride substrate having a surface inclined from the (0001) plane at an angle of 0.03° or more, or may be a GaAs, GaP, or InP substrate having a surface consisting of the (111)A plane. The angle at which the surface 52*a* of the gallium nitride film 52 formed on the GaAs or other substrate having the surface consisting of the (111)A plane is inclined is controlled as follows. Inclining the GaAs (111) plane by 0.03° in a <1-10> direction will make the (0001) plane of the obtained GaN crystal inclined by 0.03° in a <11-20> direction. Meanwhile, inclining the GaAs (111) plane by 0.03° in a <11-2> direction will make the (0001) plane of the obtained GaN crystal inclined by 0.03° in a <1-100> direction. Furthermore, inclining the GaAs (111) plane by 0.03° in a <1-10> direction and by 0.03° in a <11-2> direction will make the (0001) plane of the obtained GaN crystal inclined by 0.03° in <11-20> and 0.03° in <1-100> directions.

The gallium-nitride-film deposition method of Embodiment Mode 2 enables forming a gallium nitride film 52 in which the incidence of cracking is low. The reason for this is not exactly clear, but is thought to be as follows. Microscopic steps form on the surface 52*a* of the gallium nitride film 52, wherein the *n*-type dopant, filling the steps in from their corners, is thus more likely to enter a Ga or N site. As a result, the incidence of cracking in the gallium nitride film is reduced. Therefore, yield in manufacturing the gallium nitride film 52 can be heightened. Furthermore, the carrier concentration in the gallium nitride film 52 proves to be a high 1 x 10¹⁷ cm⁻³ or more.

After being formed, the gallium nitride film 52 is subjected to the steps represented in Figs. 2B and 2C to produce gallium nitride substrates 54.

The concentration of carries in the gallium nitride substrates 54 involving Embodiment Mode 2 is a high 1 x 10¹⁷ cm⁻³ or more. The gallium nitride substrates 54 contain *n*-type dopants. Furthermore, the incidence of cracking in the gallium nitride substrates 54 is low. As illustrated in Fig. 5, the gallium nitride substrates 54 have a surface 54*a* inclined from the (0001) plane of the gallium nitride substrates 54 at an angle of 0.03° or more. That is, the angle *θ* formed by the surface 54*a* and the (0001) plane of the gallium nitride substrates 54 is 0.03° or more. Fig. 5 is a diagram representing a gallium nitride substrate manufacturing stage.

Subsequently, through the step illustrated in Fig. 2D, the epitaxial substrates 62 are manufactured.

Gallium nitride substrates 54 involving Embodiment Mode 2 may be produced as follows. First, a gallium nitride layer 51, with the surface being crystal plane of choice-for example, the (0001) plane-is formed on the substrate 50. Next, after the substrate 50 is removed, the gallium nitride layer 51 is sliced or polished paralleling a plane inclined from the (0001) plane of the gallium nitride layer 51 at an angle of 0.03° or more. In this implementation as well, the carrier concentration in the gallium nitride substrates 54 is a high 1 x 10¹⁷ cm⁻³ or more, and the incidence of cracking in the gallium nitride substrates 54 is low.

In Embodiment Modes 1 and 2, the dislocation density of the gallium nitride film 52 is preferably 1 x 10⁷ cm⁻² or less, and is preferably 4 x 10⁶ cm⁻² or less, with 1 × 10⁶ cm⁻² or less being more preferable. The dislocation density of the gallium nitride film 52 is represented as etch pit density (EPD). A scanning electron microscope (SEM) is employed to calculate the etch pit density by counting the number of etch pits within six 100 *µ*m squares in arbitrary locations. Utilizing as the substrate 50 a gallium nitride substrate having a dislocation density of 1 x 10⁷ cm⁻² or less, for example, enables bringing dislocation density of the gallium nitride film 52 to 1 x 10⁷ cm⁻² or less. Alternatively, if a sapphire, GaAs, SiC, GaP, InP, or other substrate is utilized as the substrate 50, forming on the substrate 50 a mask layer having a pattern of apertures and forming the gallium nitride film 52 in a manner so as to bury the patterned aperture makes it possible to bring the dislocation density of the gallium nitride film 52 to 1 x 10⁷ cm⁻² or less.

With the dislocation density of the gallium nitride film 52 being 1 × 10⁷ cm⁻² or less, a gallium nitride film 52 in which the incidence of cracking is low can be formed. The reason for this is not exactly clear, but is thought to be as follows. Generally, *n*-type dopants tend to concentrate into the interspace proximate the dislocations, and if an *n*-type dopant concentrates into specific locations, the incidence of cracking rises. Herein, with the dislocation density in the gallium nitride layer being 1 x 10⁷ cm⁻² or less, in the gallium nitride layer the *n*-type dopant disperses throughout the entire film 52, and thus the incidence of cracking decreases. Therefore, yields in manufacturing the gallium nitride film 52 can be heightened.

After the gallium nitride film 52 is formed, gallium nitride substrates 54 are produced through the steps represented in Figs. 2B and 2C. The dislocation density of the gallium nitride substrates 54 produced in such a way is 1 x 10⁷ cm⁻² or less. Herein as well, the incidence of cracking in the gallium nitride substrates 54 is low. The reasons behind this have not been precisely elucidated, but are thought to be as follows. *N*-type dopants generally tend to concentrate into the interspace proximate the dislocations, and if an *n*-type dopant concentrates into specific locations, the incidence of cracking rises. Herein, with the dislocation density of the gallium nitride substrates 54 being 1 × 10⁷ cm⁻² or less, in gallium nitride substrates 54 the *n*-type dopants disperse throughout the substrate entirely, and therefore, the incidence of cracking decreases.

In the foregoing, an explanation has been made of modes for embodying the present invention, but the embodiments of the present invention disclosed above are ultimately illustrative examples; the scope of the present invention is not limited to these embodiments.

For example, the gallium nitride film 52 may be formed employing a metalorganic-hydrochloride VPE reactor in place of the hydride-VPE reactor.

Furthermore, in Embodiment Mode 1, the surface 52*a* of the gallium nitride film 52 may be inclined 0.03° or more from the (0001) plane of the gallium nitride film 52, as in Embodiment Mode 2. In this implementation, effects and performance comparable with Embodiment Mode 2 can be obtained in Embodiment Mode 1.

### Embodiment 1

While the following explains the present invention more specifically on the basis of embodiments, the present invention is not limited to the following embodiments.

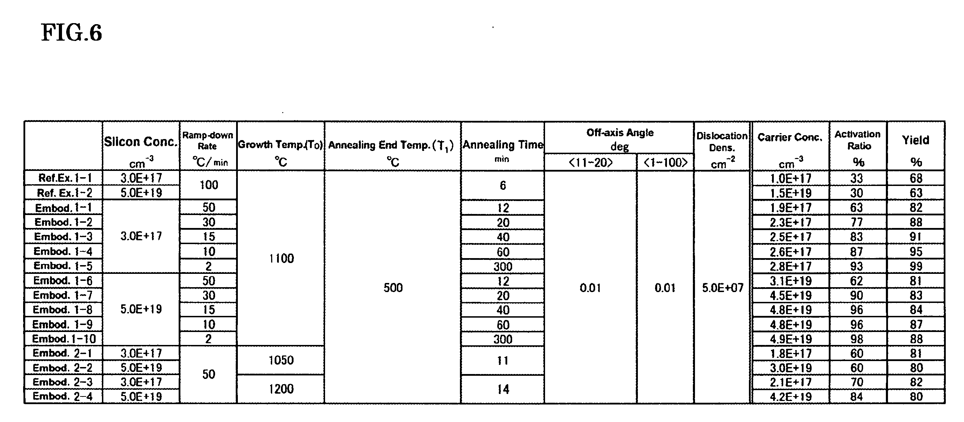

Fig. 6 is a table showing the results of tests when GaN layers were formed in Reference Examples 1-1 and 1-2, and Embodiments 1-1 through 2-4.

### Reference Example 1-1

First, with the growth temperature (*T₀*) being 1100°C, GaN layers having a silicon concentration of 3.0 × 10¹⁷ cm⁻³ were grown onto GaN substrates 50.8 mm in diameter. After being grown, the GaN layers were annealed for 6 minutes while the temperature was decreased from 1100°C to 500°C at ramp-down rate of 100°C/min.

The surface of the GaN layers was rendered a plane obtained by inclining the normal to the (0001) plane by both 0.01° in a <11-20> direction and 0.01° in a <1-100> direction. The dislocation density of the GaN layers was brought to 5.0 x 10⁷ cm⁻².

The carrier concentration in the GaN layers was 1 × 10¹⁷ cm⁻³ (activation ratio: 33 %). The percentage in which cracking did not occur in the GaN layers-that is, GaN layer manufacturing yield-was 68 % (number of samples: 100). Furthermore, the radius of curvature of the crystals in which cracking did not occur was measured with a stylus profilometer, with a resulting 85 cm average. The radius of curvature is closely related to strain in the crystal: The smaller the radius of curvature, the greater the crystal strain, wherein specifically, Fe is thought to enter the lattice interstices. It should be understood that this radius of curvature indicates a crystal's having a spread of off-axis angles within the substrate, and that the off-axis angle distribution within a substrate decreases the greater is the radius of curvature.

### Reference Example 1-2

GaN layers were formed likewise as in Reference Example 1-1, except that the silicon concentration was brought to 5.0 x 10¹⁹ cm⁻³. The carrier concentration, activation ratio, and yield were as shown in Fig. 6. Furthermore, the average of radius of curvature of the crystals in which cracking did not occur was 80 cm.

### Embodiments 1-1 to 1-10

In Embodiment 1-1 through 1-10, the ramp-down temperature was varied with GaN layers having two silicon concentrations, and tests were carried out on the GaN layers.

In Embodiment 1-1, GaN layers were formed likewise as in Reference Example 1-1, except that the ramp-down rate was made 50°C/min, and the annealing time 12 minutes. The carrier concentration, activation ratio, and yield were as set forth in Fig. 6.

In Embodiments 1-2 through 1-10, GaN layers were formed likewise as in Embodiment 1-1, except that the silicon concentration, ramp-down rate, and annealing time were varied as appropriate. The carrier concentration, activation ratio, and yield were as shown in Fig. 6.

### Embodiments 2-1 to 2-4

In Embodiments 2-1 to 2-4, the growth temperature (*T₀*) was varied with GaN layers having two silicon concentrations, and tests were carried out on the GaN layers.

In Embodiment 2-1, GaN layers were formed in a manner similar to that of Embodiment 1-1, except that the growth temperature (*T₀*) was made 1050°C and the annealing time 11 minutes. The carrier concentration, activation ratio, and yield were as shown in Fig. 6.

In Embodiments 2-2 through 2-4, GaN layers were formed in a manner similar to that of Embodiment 2-1, except that the silicon concentration, growth temperature (*T₀*), and annealing time were varied as appropriate. The carrier concentration, activation ratio, and yield were as shown in Fig. 6.

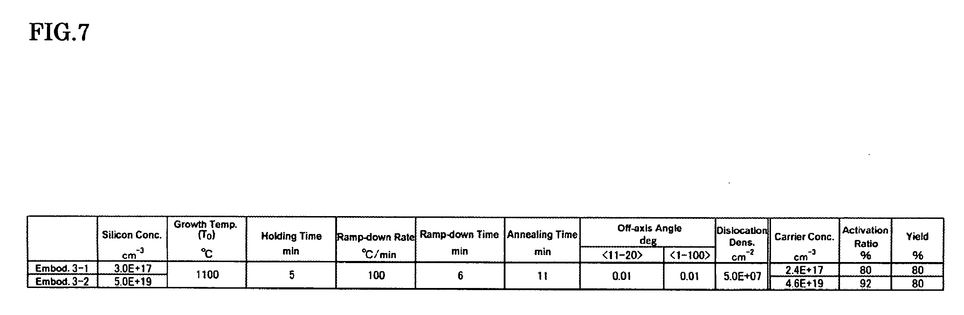

Fig. 7 is a table showing the results of tests when GaN layers were formed in Embodiments 3-1 and 3-2.

### Embodiments 3-1 and 3-2

In embodiments 3-1 and 3-2, conditions for annealing were varied with GaN layers having two silicon concentrations, and tests were carried out on the GaN layers.

In embodiment 3-1, GaN layers were formed likewise as in Embodiment 1-1, except that after the GaN layers were grown, they were annealed at temperature of 1100°C for 5 minutes, and then were further annealed for six minutes while the temperature was decreased from 1100°C at ramp-down rate of 100°C/min. The GaN layers had the carrier concentration, activation ratio, and yield as set forth in Fig. 7.

In Embodiment 3-2, apart from bringing the silicon concentration to 5.0 x 10¹⁹ cm⁻³, GaN layers were formed in a manner similar to that of Embodiment 3-1. The carrier concentration, activation ratio, and yield were as shown in Fig. 7.

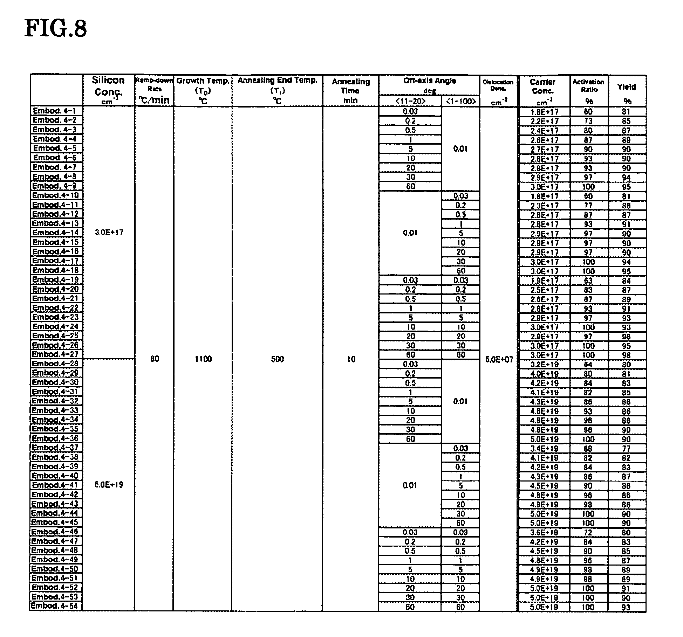

Fig. 8 is a table showing the results of tests when GaN layers were formed in Embodiments 4-1 to 4-54.

### Embodiments 4-1 to 4-54

In Embodiments 4-1 through 4-54, a GaN layer surface off-axis angle was varied with GeN layers having two silicon concentrations, and tests were carried out on the GaN layers.

In embodiment 4-1, GaN layers were formed in a manner similar to that of Embodiment 1-1, apart from having the ramp-down rate be 60°C/min, the annealing time be 10 minutes, and the surface of the GaN layers be a plane in which the normal to the GaN layers' (0001) plane was inclined by 0.03° in a <11-20> direction. The carrier concentration, activation ratio, and yield were as shown in Fig. 8.

In Embodiments 4-2 to 4-54, GaN layers were formed in a manner similar to that of Embodiment 4-1, except that the silicon concentration and off-axis angle were varied as appropriate. The carrier concentration, activation ratio, and yield were as shown in Fig. 8.

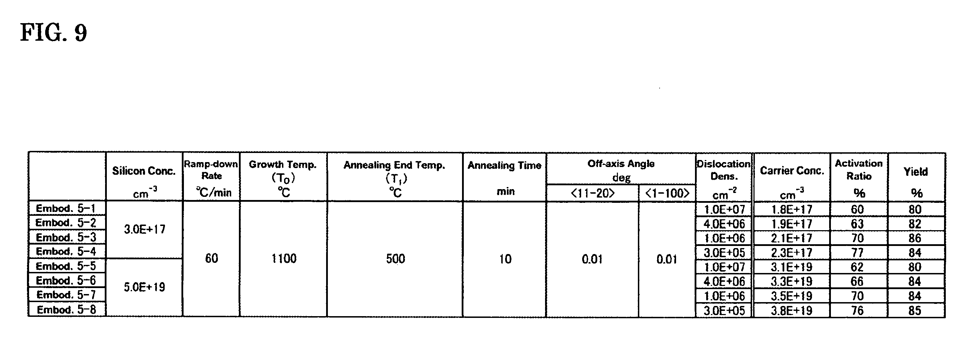

Fig. 9 is a table showing the results of tests when GaN layers were formed in Embodiments 5-1 through 5-8.

### Embodiments 5-1 to 5-8

In Embodiments 5-1 through 5-8, GaN layer dislocation density was varied with GaN layers having two silicon concentrations, and tests were carried out on the GaN layers.

In Embodiment 5-1, apart from having the ramp-down rate be 60°C/min, the annealing time be 10 minutes, and the dislocation density be 1.0 x 10⁷ cm⁻², GaN layers were formed in a manner similar to that of Embodiment 1-1. The carrier concentration, activation ratio, and yield were as shown in Fig. 9.

In Embodiments 5-2 through 5-8, apart from varying as appropriate the silicon concentration and dislocation density, GaN layers were formed in a manner similar to that of Embodiment 5-1. The carrier concentration, activation ratio, and yield were as shown in Fig. 9.

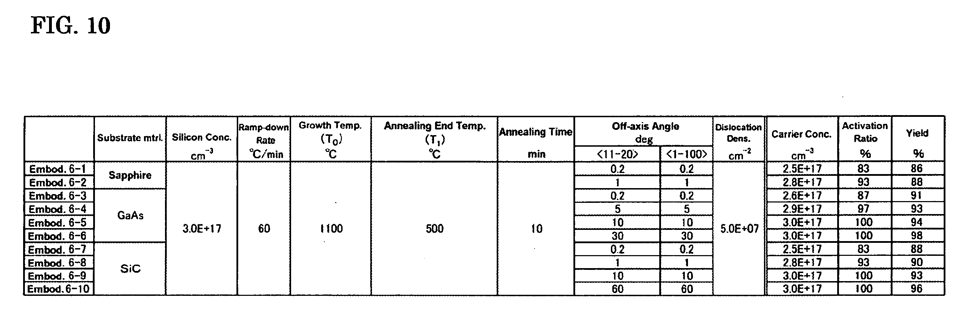

Fig. 10 is a table showing the results of tests when GaN layers were formed in Embodiments 6-1 through 6-10.

### Embodiments 6-1 to 6-10

In Embodiments 6-1 to 6-10, substrates composed of a variety of materials were used in place of the GaN substrates, and tests were carried our on the substrates composed of a variety of materials.

In Embodiment 6-1, apart from having sapphire be the substrate material, the ramp-down rate be 60°C/min, the annealing time be 10 minutes, and the surface of the GaN layers be a plane obtained by inclining the normal to the GaN layers' (0001) plane both by 0.2° in a <11-20> direction and by 0.2° in a <1-100> direction, GaN layers were formed in a manner similar to that of Embodiment 1-1. The GaN layers had the carrier concentration, activation ratio, and yield as set forth in Fig. 10.

In Embodiments 6-2 through 6-10, GaN layers were formed in a manner similar to that of Embodiment 6-1, except that the substrate material and off-axis angle were varied as appropriate. The GaN layers had the carrier concentration, activation ratio, and yield as set forth in Fig. 10.

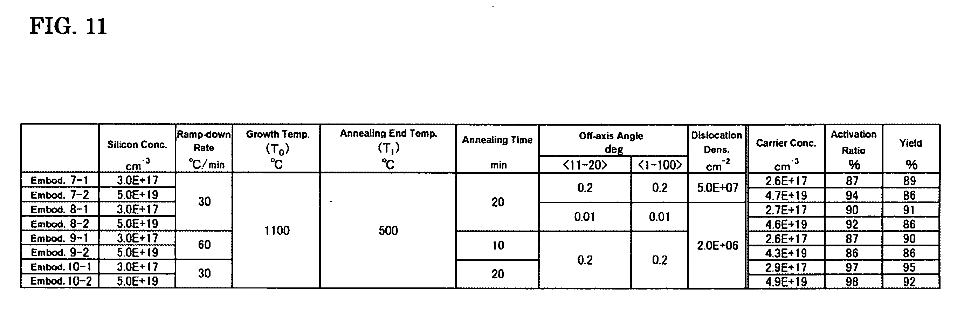

Fig. 11 is a table showing the results of tests when GaN layers were formed in Embodiments 7-1 through 10-2.

### Embodiments 7-1 and 7-2

In Embodiments 7-1 and 7-2, apart from the off-axis angle being varied, GaN layers were formed in a manner similar to that of Embodiments 1-2 and 1-7. The carrier concentration, activation ratio, and yield were as shown in Fig. 11.

### Embodiments 8-1 and 8-2

In Embodiments 8-1 and 8-2, apart from the off-axis angle being varied, GaN layers were formed in a manner similar to that of Embodiments 7-1 and 7-2. The carrier concentration, activation ratio, and yield were as shown in Fig. 11.

### Embodiments 9-1 and 9-2

In Embodiments 9-1 and 9-2, apart from the ramp-down rate and annealing time being varied, GaN layers were formed in a manner similar to that of Embodiments 7-1 and 7-2. The carrier concentration, activation ratio, and yield were as shown in Fig. 11.

### Embodiments 10-1 and 10-2

In Embodiments 10-1 and 10-2, apart from the dislocation density being varied, GaN layers were formed in a manner similar to that of Embodiments 7-1 and 7-2. The carrier concentration, activation ratio, and yield were as shown in Fig. 11.

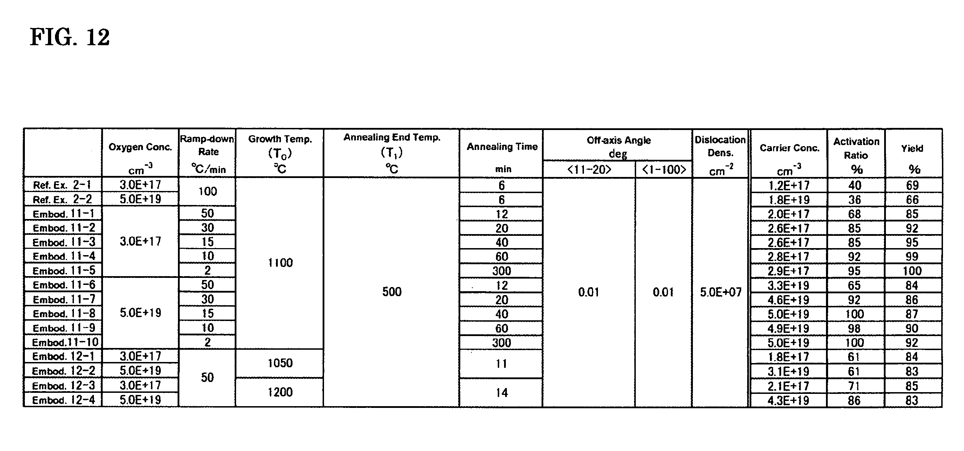

Fig. 12 is a table showing the results of tests when GaN layers were formed in Reference Examples 2-1 and 2-2, and Embodiments 11-1 through 12-4.

### Reference Example 2-1

First, with the growth temperature (*T₀*) being 1100°C, GaN layers having oxygen concentration of 3.0 x 10¹⁷ cm⁻³ were grown onto GaN substrates. After the GaN layers were grown, they were annealed for 6 minutes while the temperature was decreased from 1100°C to 500°C at ramp-down rate of 100°C/min.

The surface of the GaN layers was rendered a plane obtained by inclining the normal to the (0001) plane both by 0.01° in a <11-20> direction and by 0.01° in a <1-100> direction. The GaN layer dislocation density was brought to 5.0 × 10⁷ cm⁻².

The carrier concentration in the GaN layers was 1.2 × 10¹⁷ cm⁻³ (activation ratio: 40 %). Percentage in which cracking did not occur in the GaN layers-that is, GaN layer manufacturing yield-was 69 % (number of samples: 100).

### Reference Example 2-2

Apart from having the oxygen concentration be 5.0 x 10¹⁹ cm⁻³, GaN layers were formed in a manner similar to that of Reference Example 2-1. The GaN layers had the carrier concentration, activation ratio, and yield as shown in Fig. 12.

### Embodiments 11-1 to 11-10

In embodiments 11-1 through 11-10, the ramp-down rate was varied with GaN layers having two oxygen concentrations, and tests were carried out the GaN laeyrs.

In embodiment 11-1, apart from having the ramp-down rate be 50°C/min, and the annealing time be 12 minutes, GaN layers were formed in a manner similar to that of Reference Example 2-1. The GaN layers had the carrier concentration, activation ratio, and yield as set forth in Fig. 12.

In Embodiments 11-2 through 11-10, apart from the oxygen concentration, ramp-down rate, and annealing time being varied as appropriate, GaN layers were formed in a manner similar to that of Embodiment 11-1. The GaN layers had the carrier concentration, activation ratio, and yield as set forth in Fig. 12.

### Embodiments 12-1 to 12-4

In embodiments 12-1 through 12-4, the growth temperature (*T₀*) was varied with the GaN layers having two oxygen concentrations, and tests were carried out on the GaN layers.

In Embodiment 12-1, GaN layers were formed in a manner similar to that of Embodiment 11-1, except that the growth temperature (*T₀*) was put at 1050°C, and the annealing time at 11 minutes,. The carrier concentration, activation ratio, and yield were as shown in Fig. 12.

In Embodiments 12-2 to 12-4, GaN layers were formed in a manner similar to that of Embodiment 12-1, except that the oxygen concentration, growth temperature (*T₀*), and annealing time were varied as appropriate. The GaN layers had the carrier concentration, activation ratio, and yield as set forth in Fig. 12.

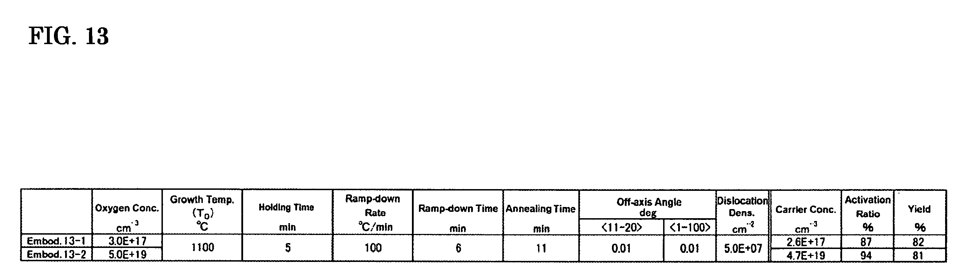

Fig. 13 is a table showing the results of tests when GaN layers were formed in Embodiments 13-1 and 13-2.

### Embodiments 13-1 and 13-2

In embodiments 13-1 and 13-2, conditions for annealing were varied with GaN layers having two oxygen concentrations, and tests were carried out on the GaN layers.

In embodiment 13-1, GaN layers were formed in a manner similar to that of Embodiment 11-1, except that that after the GaN layers were grown, they were annealed at temperature of 1100°C for 5 minutes, and then were additionally annealed for six minutes while the temperature was decreased from 1100°C at a ramp-down rate of 100°C/min. The carrier concentration, activation ratio, and yield were as shown in Fig. 13.

In Embodiment 13-2, apart from having the oxygen concentration be 5.0 x 10¹⁹ cm⁻³, GaN layers were formed in a manner similar to that of Embodiment 13-1. The carrier concentration, activation ratio, and yield were as shown in Fig. 13.

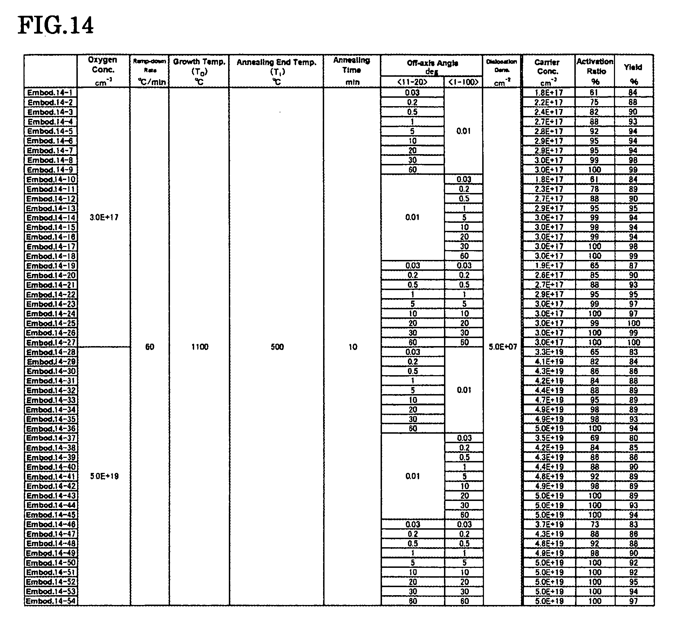

Fig. 14 is a table showing the results of tests when GaN layers were formed in Embodiments 14-1 to 14-54.

### Embodiments 14-1 to 14-54

In embodiments 14-1 through 14-54, GaN layer surface off-axis angle was varied with GaN layers having two oxygen concentrations, and tests were carried out on the GaN layers.

In embodiment 14-1, GaN layers were formed in a manner similar to that of Embodiment 11-1, apart from having the ramp-down rate be 60°C/min, the annealing time be 10 minutes, and the surface of the GaN layers be a plane obtained by inclining the normal to the GaN layers' (0001) plane by 0.03° in a <11-20> direction. The GaN layers had the carrier concentration, activation ratio, and yield as set forth in Fig. 14.

In Embodiments 14-2 to 14-54, apart from varying as appropriate the oxygen concentration and off-axis angle, GaN layers were formed in a manner similar to that of Embodiment 14-1. The GaN layers had the carrier concentration, activation ratio, and yield as shown in Fig. 14.

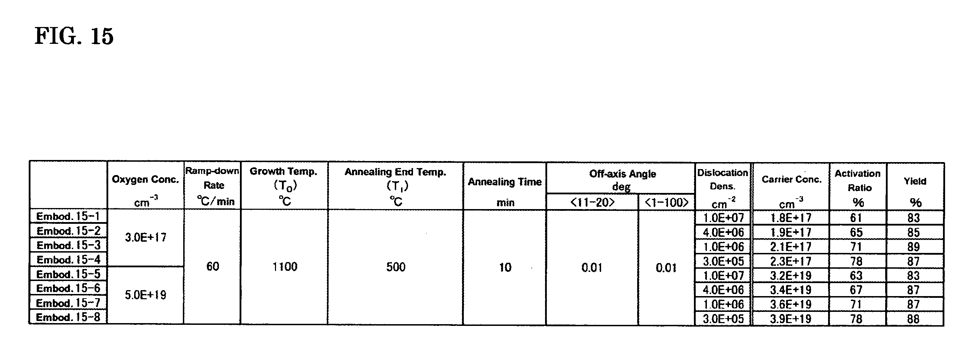

Fig. 15 is a table showing the results of tests when GaN layers were formed in Embodiments 15-1 through 15-8.

### Embodiments 15-1 to 15-8

In Embodiments 15-1 to 15-8, the GaN layer dislocation density was varied with GaN layers having two different oxygen concentrations, and tests were carried out on the GaN layers.

In Embodiment 15-1, apart from having the ramp-down rate be 60°C/min, the annealing time be 10 minutes, and the dislocation density be 1.0 x 10⁷ cm⁻², GaN layers were formed in a manner similar to that of Embodiment 11-1. The carrier concentration, activation ratio, and yield were as shown in Fig. 15.

In embodiments 15-2 through 15-8, apart from varying as appropriate the oxygen concentration and dislocation density, GaN layers were formed in a manner similar to that of Embodiment 15-1. The GaN layers had the carrier concentration, activation ratio, and yield as set forth in Fig. 15.

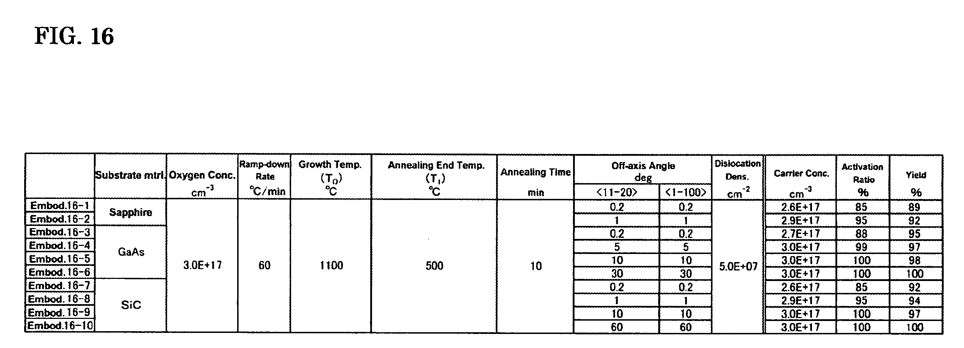

Fig. 16 is a table showing the results of tests when GaN layers were formed in Embodiments 16-1 through 16-10.

### Embodiments 16-1 to 16-10

In Embodiments 16-1 to 16-10, substrates composed of a variety of materials were utilized in place of GaN substrates, and tests were carried out on the substrates composed of a variety of materials.

In Embodiment 16-1, GaN layers were formed in a manner similar to that of Embodiment 11-1, apart from having sapphire be the substrate material, the ramp-down rate be 60°C/min, the annealing time be 10 minutes, and the surface of the GaN layers be a plane obtained by inclining the normal to the GaN layers' (0001) plane both by 0.2° in a <11-20> direction and by 0.2° in a <1-100> direction. The GaN layers had the carrier concentration, activation ratio, and yield as set forth in Fig. 16.

In embodiments 16-2 through 16-10, apart from varying as appropriate the substrate material and off-axis angle, GaN layers were formed in a manner similar to that of Embodiment 16-1. The carrier concentration, activation ratio and yield were as shown in Fig. 16.

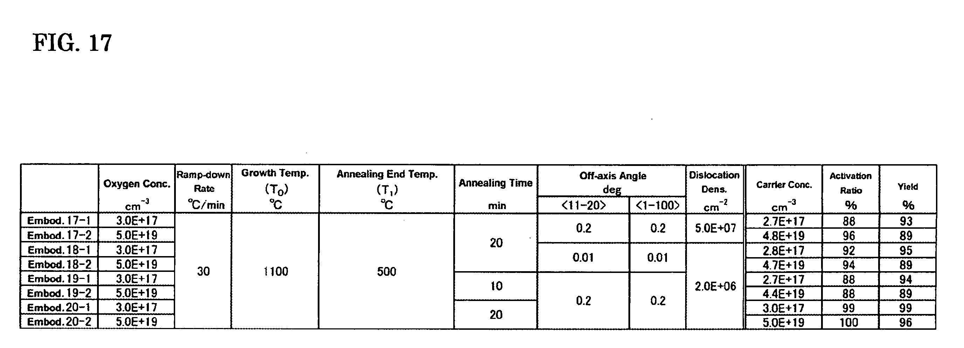

Fig. 17 is a table showing the results of tests when GaN layers were formed in Embodiments 17-1 through 20-2.

### Embodiments 17-1 and 17-2

In Embodiments 17-1 and 17-2, apart from varying the off-axis angle, GaN layers were formed in a manner similar to that of Embodiment 11-2 and 11-7. The GaN layers had the carrier concentration, activation ratio, and yield as set forth in Fig. 17.

### Embodiments 18-1 and 18-2

In Embodiments 18-1 and 18-2, apart from varying the off-axis angle, GaN layers were formed in a manner similar to that of Embodiment 17-1 and 17-2. The GaN layers had the carrier concentration, activation ratio, and yield as set forth in Fig. 17.

### Embodiments 19-1 and 19-2

In Embodiments 19-1 and 19-2, apart from varying the ramp-down rate and annealing time, GaN layers were formed in a manner similar to that of Embodiments 17-1 and 17-2. The GaN layers had the carrier concentration, activation ratio, and yield as set forth in Fig. 17.

### Embodiments 20-1 and 20-2

In embodiments 20-1 and 20-2, apart from varying the dislocation density, GaN layers were formed in a manner similar to that of Embodiment 17-1 and 17-2. The carrier concentration, activation ratio, and yield were as shown in Fig. 17.

Furthermore, in these Embodiments 1-1 through 20-2, there is a correlation between the yield and the crystal radius of curvature-that is, the radius of curvature of crystals with yields of 80 % or more was 150 cm or more, the radius of curvature of crystals with yields of 84 % or more was 180 cm or more, the radius of curvature of crystals with yields of 90 % or more was 260 cm or more, and the radius of curvature of crystals with yields of 95 % or more was 300 cm or more.

Subsequently, the semiconductor devices in which the epitaxial substrates 62 manufactured by forming the nitride semiconductor layers 56, 58, and 60 on the gallium nitride substrates 54 produced by above Embodiment Modes 1 and 2 will be described. As the semiconductor devices, a LED, LD, HEMT, Schottky diode, and vertical MIS transistor are cited below.

### LED

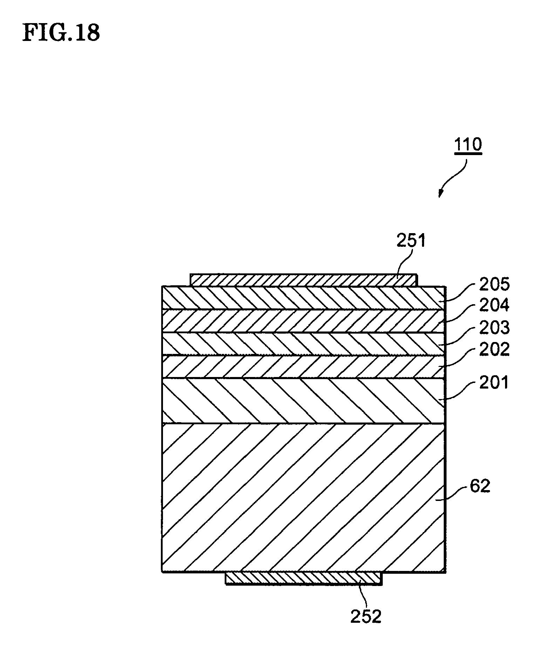

Fig. 18 is a cross-sectional view of a light emitting diode (LED) 110. As illustrated in Fig. 18, the LED 110 includes: a semiconductor layer in which an *n*-type GaN layer 201, *n*-type AlGaN layer 202, emission layer 203, *p*-type AlGaN layer 204, and a *p*-type GaN layer 205 are successively formed on the top surface of the epitaxial substrates 62; a *p*-side electrode 251 on the top surface of the top surface of the *p*-type GaN layer 205; and an *n*-side electrode 252 on the under surface of the epitaxial substrates 62.

The emission layer 203, for example, may be structured into a multi-quantum well (MQW) in which a plurality of GaN -In_{0.2}Ga_{0.8}N double-layered structures are laminated.

The LED 110 is prepared in the following way, for example. First, as device manufacturing process, the *n*-type GaN layer 201, *n*-type AlGaN layer 202, emission layer 203, *p*-type AlGaN layer 204, and *p*-type GaN layer 205 are successively formed by MOCVD on the top surface of the epitaxial substrates 62. Subsequently, the 100 nm-thick *p*-side electrode 251 is formed on the top surface of the *p*-type GaN layer 205. Additionally, the *n*-side electrode 252 is formed on the under surface of the epitaxial substrates 62 to produce the LED that is the LED 110.

### LD

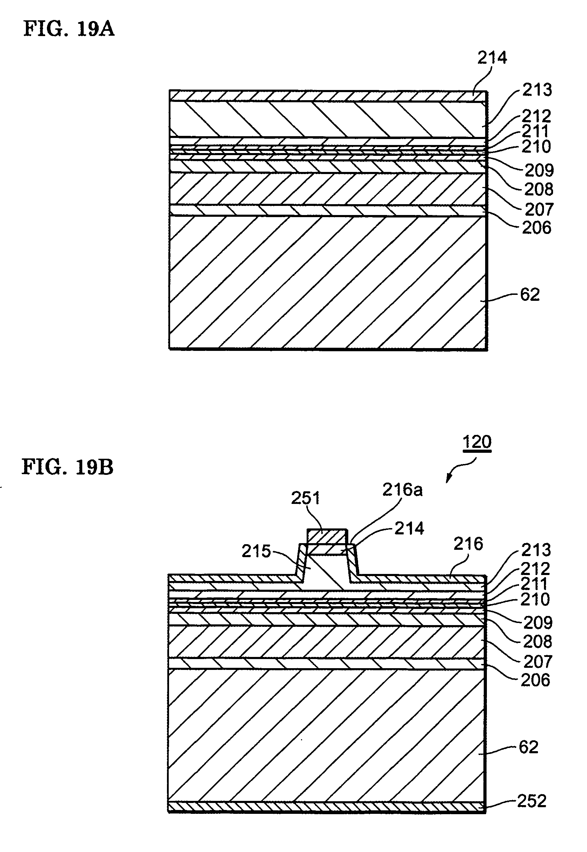

Fig. 19 is a cross-sectional view of a laser diode (LD) 120. As illustrated in Fig. 19B, the LD 120 includes: a semiconductor layer in which an *n*-type GaN buffer layer 206, *n*-type AlGaN cladding layer 207, *n*-type GaN optical waveguide layer 208, active layer 209, undoped InGaN anti-degradation layer 210, *p*-type AlGaN cap layer 211, *p*-type GaN optical waveguide layer 212, *p*-type AlGaN cladding layer 213, and *p*-type GaN contact layer 214 are successively formed on the top surface of the epitaxial substrates 62; the *p*-side electrode 251 on the top surface of the *p*-type GaN contact layer 214; and the *n*-side electrode 252 on the under surface of the epitaxial substrates 62.

The LD 120 was prepared, for example, in the following way. First, as device manufacturing process, as illustrate in Fig. 19A, the following layers are successively formed on the top surface of the epitaxial substrates 62: the *n*-type GaN buffer layer 206, *n*-type AlGaN cladding layer 207, *n*-type GaN optical waveguide layer 208, active layer 209, undoped InGaN anti-degradation layer 210, *p*-type AlGaN cap layer 211, *p*-type GaN optical waveguide layer 212, *p*-type AlGaN cladding layer 213, *p*-type GaN contact layer 214. Next, a SiO₂ film is formed by CVD on the entire top surface of the *p*-type GaN contact layer 214, and then a pattern is formed by lithography. Subsequently, as illustrate in Fig. 19B, a ridge 215 is formed so as to have the predetermined depth in the thickness direction in the *p*-type AlGaN cladding layer 213. After the formation of the ridge 251, the SiO₂ film is removed, and then a SiO₂ insulating film 216 is formed on the entire substrate surface. Next, the *p*-side electrode 251 is formed only on the top surface of the *p*-type GaN contact layer 214 by resist pattern formation and etching. And then, the *n*-side electrode 252 is formed on the under surface of the epitaxial substrates 62. As a result, the LD that is the LD 120 is produced.

Herein, for the formation of the SiO₂ film, vacuum vapor deposition and sputtering, and other techniques may be used, and for etching of the SiO₂ film, reactive ion etching (RIE) in which a fluorine-containing etching gas is employed may be advantageously used.

### HEMT

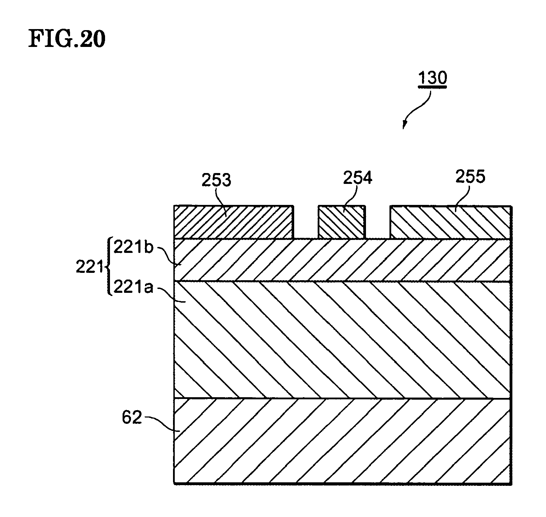

Fig. 20 is a cross-sectional view of a high electron mobility transistor (HEMT) 130. As illustrated in Fig. 20, in the HEMT 130, an *i*-type GaN layer 221*a*, and *i*-type AlGaN layer 221*b* are successively formed as an at least single-lamina III nitride semiconductor layer 221 on the top surface of the epitaxial substrates 62, and furthermore the HEMT 130 includes a source electrode 253, gate electrode 254, and drain electrode 255 on the top surface of the *i*-type AlGaN layer 221*b*.

The HEMT 130 is prepared in the following way, for example. As device manufacturing process, as illustrated in Fig. 20, after the *i*-type GaN layer 221*a*, and the *i*-type AlGaN layer 221*b* are grown onto the top surface of the epitaxial substrates 62, the source electrode 253 and drain electrode 255 are formed on the *i⁻*type AlGaN layer 221*b* by photolithography and liftoff techniques, and then the gate electrode 254 is also formed, to produce the HEMT that is the HEMT 130.

### Schottky Diode

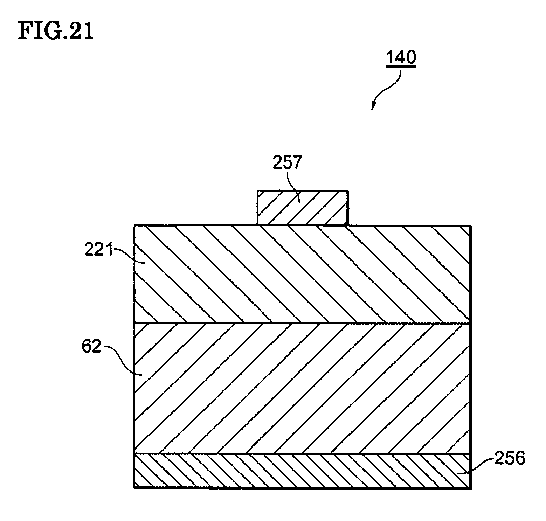

Fig. 21 is a cross sectional view of a Schottky diode 140. As illustrated in Fig. 21, the Schottky diode 140 has on the top surface of the epitaxial substrates 62 an *n⁻*-type GaN layer 221 as an at least single-lamina III nitride semiconductor layer, and is provided with an ohmic electrode 256 on the under surface of the epitacial substrates 62. Furthermore, the Schottky diode 140 is provided with a Schottky electrode 257 on the top surface of the *n*-type GaN layer 221.

The Schottky diode 140 is prepared in the following way, for example. As device manufacturing process, as illustrated in Fig. 21, the *n*-type GaN layer 221 is grown onto the epitaxial substrates 62 by MOCVD. Next, the ohmic electrode 256 is formed on a front part of the under surface of the epitaxial substrates 62. Additionally, the Schottky electrode 257 is formed on the *n*⁻-type GaN layer 221 by photolithography and liftoff techniques. In such a way, the Schottky diode that is the Schottky diode 140 can be produced.

### Vertical MIS Transistor

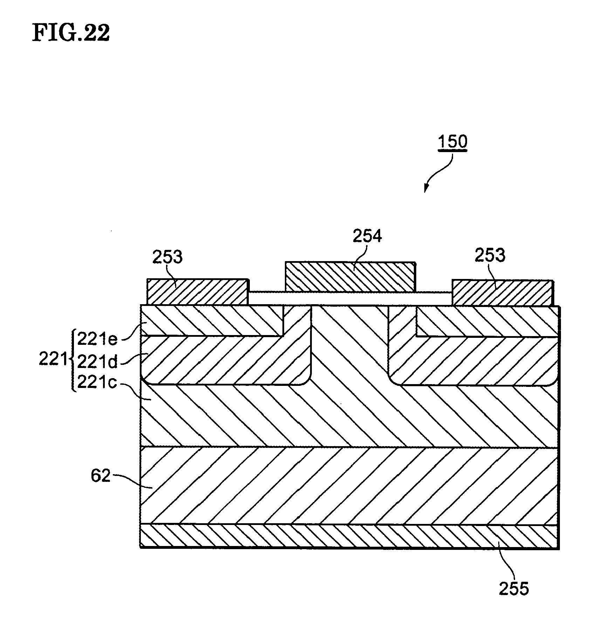

Fig. 22 is a cross-sectional view of a vertical metal insulator semiconductor (MIS) transistor 150. As illustrated in Fig. 22, in the vertical MIS transistor 150, an *n*-type GaN layer 221*c* is formed on the top surface of the epitaxial substrate 26 as the at least single-lamina III nitride semiconductor layer 221, and a *p*-type GaN layer 221*d* and *n*⁺-type GaN layer 221*e* are formed in partial regions on the top surface of the *n*-type GaN layer 221*c*. Furthermore, the vertical MIS transistor 150 is provided with the drain electrode 255 on the under surface of the epitaxial substrates 62, and with the source electrode 253 on the top surface of the *n*⁺-type GaN layer 221*e*.

The vertical MIS transistor 150 of the embodiment modes of the present invention is prepared in the following way, for example. As device manufacturing process, as illustrated in Fig. 22, the *n*-type GaN layer 221*c* is formed on the epitaxial substrates 62 by MOCVD. Subsequently, the *p*-type GaN layer 221 d and *n*⁺-type GaN layer 221*e* are successively formed by selective ion implantation in the partial regions on the top surface of the *n*⁻-type GaN layer 221*c*. Next, the *n⁻*-type GaN layer 221*c* is protected with the SiO₂ film, and then annealing is performed to activate the implanted ions. After the SiO₂ film is formed as insulating film for vertical MIS by plasma enhanced chemical vapor deposition (P-CVD), a part of the insulating film for vertical MIS is etched by photolithography, and by selective etching in which buffered hydrofluoric acid is employed, and the source electrode 253 is formed on the top surface of the n⁺-type GaN layer 221*e* by liftoff technique. Next, the gate electrode 254 is formed on the insulating film for vertical MIS by photolithography and liftoff techniques. Furthermore, the drain electrode 255 is formed on the entire under surface of the epitaxial substrates 62. As a result, the vertical MIS transistor that is the vertical MIS transistor 150 is produced.

Herein, cracking characterization in the semiconductor device manufacturing process is carried out after epitaxial growth and electrode formation are completed, and chips are formed by dicing or cleavage.

### Device Evaluation

The properties of the semiconductor devices prepared in the processes of manufacturing the semiconductor devices were evaluated in the following way. First, device characteristics of semiconductor devices equivalent to the comparison examples for each semiconductor devices were measured-namely, emission intensity of the LEDs, laser lifetime of the LDs, and respective "ON" resistances of the HEMTs, Schottky diodes, and vertical MIS transistors were measured-and the average and standard deviation *σ* of these measurements were computed. On this basis, device characteristics regarding the respective semiconductor devices of the embodiments were measured, and those whose results were at or above <average - *σ*> of the device characteristics of the comparative examples were taken to be qualifying. Likewise with the devices included in the comparative examples: Those of the comparative examples whose device characteristics had results at or above <average - *σ*> were taken to be qualifying.

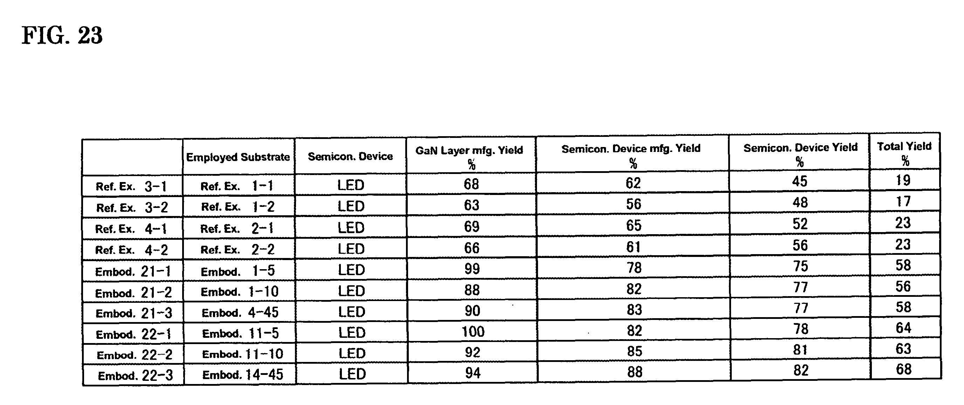

Figs. 23 to 25 are tables showing yields of the prepared semiconductor devices.

First, yields of the semiconductor devices (LEDs) involving Reference Examples 3-1 to 4-2, and Embodiments 21-1 to 22-3 are set forth in Fig. 23.

### Reference Example 3-1

In Reference Example 3-1, epitaxial substrates were prepared employing the GaN layers formed in Reference Example 1-1, and semiconductor devices (LEDs) were fabricated employing the epitaxial substrates. The method of fabricating the semiconductor devices (LEDs) is as described above. The percentage of GaN layers in which cracking did not occur during growth-that is, the GaN layer manufacturing yield-was 68 % as noted above. Furthermore, the percentage of semiconductor devices in which cracking did not occur during the process of their manufacture-that is, semiconductor device manufacturing yield-was 62 %, and the yield in terms of evaluation of the semiconductor device properties was 45 %. Therefore, the total yield over the entire course of preparing the semiconductor devices was 19 %.

### Reference Examples 3-2, 4-1, and 4-2

In Reference Examples 3-2, 4-1 and 4-2, semiconductor devices were fabricated in the same way as in Reference Example 3-1, apart from varying the epitaxial substrates employed. The GaN layer manufacturing yield, semiconductor device manufacturing yield, yield in terms of evaluation of the fabricated semiconductor devices' properties, and total yield over the entire course of preparing the semiconductor devices are as set forth in Fig. 23.

### Embodiments 21-1 to 22-3

In Embodiments 21-1 to 22-3, the epitaxial substrates used in the fabrication of the semiconductor devices were each varied, and tests were carried out on the semiconductor devices.

In Embodiment 21-1, semiconductor devices were fabricated likewise as in Reference Example 3-1, apart from having the substrates employed be the epitaxial substrates utilizing the GaN layers formed in Embodiment 1-5. The GaN layer manufacturing yield, semiconductor device manufacturing yield, yield with respect to rating of the properties of the fabricated semiconductor devices, and total yield over the entire course of preparing the semiconductor devices are set forth in Fig. 23.

### Embodiments 21-2 to 22-3

In Embodiments 21-2 to 22-3, semiconductor devices were fabricated in the same way as in Embodiment 21-1, apart from varying the employed epitaxial substrates. The GaN layer manufacturing yield, semiconductor device manufacturing yield, throughput in terms of rating the properties of the fabricated semiconductor devices, and total yield in the semiconductor fabrication processes in their entirety are set forth in Fig. 23.

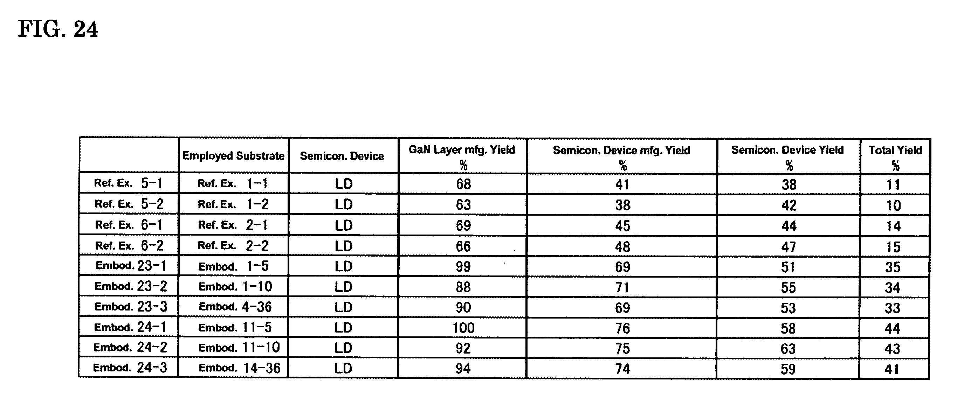

The yields of semiconductor devices (LDs) involving Reference Examples 5-1 to 6-2, and Embodiments 23-1 to 24-3 are set forth in Fig. 24.

### Reference Example 5-1

In Reference Example 5-1, epitaxial substrates were prepared employing the GaN layers formed in Reference Example 1-1, and semiconductor devices (LDs) were prepared employing the epitaxial substrates. The method of fabricating the semiconductor devices (LDs) is as described above. The percentage in which cracking did not occur during growth of the GaN layers-that is, GaN layer manufacturing yield-was 68 % as described above. Furthermore, the percentage in which cracking did not occur during the process of manufacturing the semiconductor devices-that is, semiconductor device manufacturing yield-was 41 %, and the yield in terms of evaluation of the properties of the fabricated semiconductor device was 38 %. Therefore, the total yield over the entire course of fabricating the semiconductor devices was 11 %.

### Reference Examples 5-2, 6-1, and 6-2

In Reference Examples 5-2, 6-1, and 6-2, semiconductor devices were fabricated in the same way as in Reference Example 5-1, apart from varying the employed epitaxial substrates. The GaN layer manufacturing yield, semiconductor device manufacturing yield, yield in terms of rating the fabricated semiconductor devices' properties, and total yield in the entire process of preparing the semiconductor devices are set forth in Fig. 24.

### Embodiments 23-1 to 24-3

In Embodiments 23-1 to 24-3, the epitaxial substrate used for semiconductor device preparation was varied with semiconductor devices, and tests were carried out on the semiconductor devices.

In Embodiment 23-1, semiconductor devices were fabricated in the same way as in Reference Example 5-1, apart from having the substrates employed be the epitaxial substrates utilizing the GaN layers formed in Embodiment 1-5. The GaN layer manufacturing yield, semiconductor device manufacturing yield, yield in terms of rating the fabricated semiconductor devices' properties, and total yield over the entire course of fabricating the semiconductor devices are set forth in Fig. 24.

### Embodiment 23-2 to 24-3

In Embodiments 23-2 to 24-3, semiconductor devices were fabricated in the same way as in Embodiment 23-1, apart from varying the employed epitaxial substrates. The GaN layer manufacturing yield, semiconductor device manufacturing yield, yield in terms of evaluation of the properties of the fabricated semiconductor devices, and total yield over the entire course of fabricating the semiconductor devices are set forth in Fig. 24.

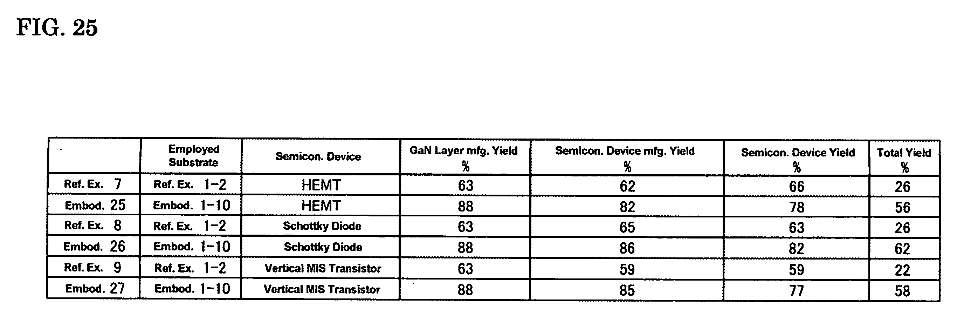

The yields of the semiconductor devices (HEMTs, Schottky diodes, and vertical MIS transistors) involving Reference Examples 7 through 9, and Embodiments 25 through 27 are set forth in Fig. 25.

### Reference Example 7

In Reference Example 7, epitaxial substrates were prepared employing the GaN layers formed in Reference Example 1-2, and semiconductor devices (HEMTs) were prepared employing the epitaxial substrates. The method of fabricating the semiconductor devices (HEMTs) is as described above. The percentage in which cracking did not occur during growth of the GaN layers-that is, GaN layer manufacturing yield-was 63 % as described above. Furthermore, the percentage in which cracking did not occur during the process of manufacturing the semiconductor devices-that is, semiconductor device manufacturing yield-was 62 %, and yield in terms of rating the fabricated semiconductor devices' properties was 66 %. Therefore, the total yield in the entire process of preparing the semiconductor devices was 26 %.

### Embodiment 25

In embodiment 25, the epitaxial substrates used for the semiconductor device preparation were varied with semiconductor devices, and tests were carried out on the semiconductor devices.

In embodiment 25, semiconductor devices were fabricated in the same way as in Reference Example 7, apart from having the substrates be the epitaxial substrates utilizing the GaN layers formed in Embodiment 1-10. The GaN layer manufacturing yield, semiconductor device manufacturing yield, throughput in terms of rating the fabricated semiconductor devices' properties, and total yield over the entire course of fabricating the semiconductor devices are set forth in Fig. 25.

### Reference Example 8

In Reference Example 8, epitaxial substrates were prepared employing the GaN layers formed in Reference Example 1-2, and semiconductor devices (Schottky diodes) were prepared employing the epitaxial substrates. The method of fabricating the semiconductor devices (Schottky diodes) is as described above. The percentage in which cracking did not occur during growth of the GaN layers-that is, GaN layer manufacturing yield-was 63 % as described above. Furthermore, the percentage in which cracking did not occur during the process of manufacturing the semiconductor devices-that is, semiconductor device manufacturing yield-was 65 %, and the yield in terms of evaluation of the fabricated semiconductor devices' properties was 63 %. Therefore, the total yield in the entire process of preparing the semiconductor devices was 26 %.

### Embodiment 26

In embodiment 26, the epitaxial substrates used for the semiconductor device manufacturing were varied with semiconductor devices, and tests were carried out on the semiconductor devices.

In embodiment 26, semiconductor devices were fabricated in the same way as in Reference Example 8, apart from having the substrates employed be the epitaxial substrates utilizing the GaN layers formed in Embodiment 1-10. The GaN layer manufacturing yield, semiconductor device manufacturing yield, throughput in terms of evaluation of the fabricated semiconductor devices' properties, and total yield in the entire process of preparing the semiconductor devices are set forth in Fig. 25.

### Reference Example 9

In Reference Example 9, epitaxial substrates were prepared employing the GaN layers formed in Reference Example 1-2, and semiconductor devices (vertical MIS transistors) were prepared employing the epitaxial substrates. The method of fabricating the semiconductor devices (vertical MIS transistors) is as described above. The percentage in which cracking did not occur during growth of the GaN layers-that is, GaN layer manufacturing yield- was 63 % as described above. Furthermore, the percentage in which cracking did not occur during the process of manufacturing the semiconductor devices-that is, semiconductor device manufacturing yield-was 59 %, and yield with respect to rating of fabricated semiconductor devices' properties was 59 %. Therefore, the total yield in the entire process of preparing the semiconductor devices was 22 %.

### Embodiment 27

In Embodiment 27, the epitaxial substrates used for the semiconductor device manufacturing were varied with semiconductor devices, and tests were carried out on the semiconductor devices.

In Embodiment 27, semiconductor devices were fabricated in the same way as in Reference Example 9, apart from having the substrates employed be the epitaxial substrates utilizing the GaN layers formed in Embodiment 1-10. The GaN layer manufacturing yield, semiconductor device manufacturing yield, throughput in terms of evaluation of the fabricated semiconductor devices' properties, and total yield in the entire process of preparing the semiconductor devices are set forth in Fig. 25.

As just described, in above semiconductor devices, employing epitaxial substrates in which gallium nitride layers formed by the formation method of Embodiments Modes 1 and 2 were utilized makes it possible to lower the incidence of cracking during the processes of manufacturing the semiconductor devices. Furthermore, throughput in terms of semiconductor-device quality evaluation can be heightened. As a result, total yield throughout the processes of fabricating the semiconductor devices can be raised.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A method of deposition-forming a gallium nitride film having a carrier concentration of at least 1 x 10¹⁷ cm⁻³, the gallium-nitride-film deposition method comprising:
a step of forming on a substrate a gallium nitride layer containing an *n*-type dopant; and
a step of heating the gallium nitride layer formed on the substrate.

2. A gallium-nitride-film deposition method as set forth in claim 1, wherein the gallium nitride layer is heated at a temperature of 800°C or more for 5 minutes or more.

3. A gallium-nitride-film deposition method as set forth in claim 1 or claim 2, wherein the gallium nitride layer is heated at a ramp-down rate of 50°C/min or less.

4. A gallium-nitride-film deposition method as set forth in any of claims 1 through 3, wherein the surface of the gallium nitride layer is inclined from the gallium nitride layer's (0001) plane at an angle of 0.03° or more.

5. A gallium-nitride-film deposition method as set forth in any of claims 1 through 4, wherein the gallium nitride layer has a dislocation density of 1 × 10⁷ cm⁻² or less.

6. A gallium-nitride-film deposition method, comprising:
a step of forming onto a substrate a gallium nitride layer having a carrier concentration of 1 × 10¹⁷ cm⁻³ or more and including an *n*-type dopant; wherein
the surface of the gallium nitride layer is inclined from the gallium nitride layer's (0001) plane at an angle of 0.03° or more.

7. A gallium-nitride-film deposition method as set forth in claim 6, wherein the gallium nitride layer has a dislocation density of 1 x 10⁷ cm⁻² or less.

8. A gallium nitride substrate **characterized by**:
carrier concentration in the gallium nitride substrate being 1 x 10¹⁷ cm⁻³ or more;
incorporating an *n*-type dopant; and
having a surface inclined from the gallium nitride substrate's (0001) plane at an angle of 0.03° or more.

9. A gallium nitride substrate as set forth in claim 8, wherein the dislocation density of the gallium nitride substrate is 1 x 10⁷ cm⁻² or less.
